**Europäisches Patentamt**

**European Patent Office**

**Office européen des brevets**

(11) Numéro de publication : **0 324 524 B1**

(12) **FASCICULE DE BREVET EUROPEEN**

(45) Date de publication du fascicule du brevet :
**03.06.92 Bulletin 92/23**

(51) Int. Cl.$^5$ : **H03M 1/30, G01D 5/245**

(21) Numéro de dépôt : **89200046.4**

(22) Date de dépôt : **10.01.89**

(54) **Détecteur de positionnement.**

(30) Priorité : **15.01.88 FR 8800431**

(43) Date de publication de la demande :
**19.07.89 Bulletin 89/29**

(45) Mention de la délivrance du brevet :
**03.06.92 Bulletin 92/23**

(84) Etats contractants désignés :
**DE FR GB**

(56) Documents cités :
**US-A- 3 050 718**
**US-A- 3 465 331**
**ELECTRONIQUE INDUSTRIELLE, no. 136, septembre 1970, pages 511-516, Paris, FR; D. KLEIN: "Propos insolites sur le Codeur àContact"**

(73) Titulaire : **TELECOMMUNICATIONS RADIOELECTRIQUES ET TELEPHONIQUES T.R.T.**
**88, rue Brillat Savarin**
**F-75013 Paris (FR)**
(84) **FR**

Titulaire : **N.V. Philips' Gloeilampenfabrieken**
**Groenewoudseweg 1**
**NL-5621 BA Eindhoven (NL)**
(84) **DE GB**

(72) Inventeur : **Petitjean, Gilbert**
**Societe Civile S.P.I.D. 209, rue de l'Université F-75007 Paris (FR)**
Inventeur : **Lebourg, Michel**
**Societe Civile S.P.I.D. 209, rue de l'Université F-75007 Paris (FR)**

(74) Mandataire : **Caron, Jean et al**
**Société Civile S.P.I.D. 156, Boulevard Haussmann**
**F-75008 Paris (FR)**

EP 0 324 524 B1

## Description

L'invention concerne un détecteur de positionnement, en particulier un dispositif pour fournir une valeur indiquant la position d'un objet pouvant occuper au moins trois positions consécutives, comportant un arrangement avec plusieurs bornes dont chacune correspondant à une des positions, l'application d'une tension continue à chaque instant sur une et une seule desdites bornes indiquant la présence d'un objet dans la position correspondante.

De tels dispositifs sont utilisés par exemple pour transmettre la position d'un organe mobile à un organe d'affichage, par exemple la position d'une girouette, ou pour transmettre la position d'un organe de commande, par exemple un bouton rotatif ou un curseur à plots à actionner à la main, vers un organe à commander.

Des dispositifs électromécaniques connus sont constitués de détecteurs mécaniques de déplacement (cames, rochets, croix de Malte, etc...) actionnant des contacts électriques. Ces dispositifs sont généralement volumineux, peu fiables, et n'acceptent que de faibles vitesses de déplacement.

Il existe aussi des codeurs optiques formés d'une source de lumière (diodes électroluminescentes, généralement), de photo-détecteurs, et d'un système de focalisation. Ces senseurs optiques, sans contact, sont très répandus. Ils sont assez volumineux et inutilisables dans des équipements où les contraintes de tenue en température sont très sévères.

Des dispositifs électro-mécaniques déphaseurs sont basés sur des systèmes (potentiomètres sinus-cosinus, résolvers, etc) délivrant des signaux déphasés en fonction du sens de rotation. Ces composants spéciaux sont volumineux, de durée de vie limitée, et relativement coûteux.

Un dispositif d'analyse temporelle par microprocesseur pourrait être envisagé. Mais cette réalisation serait complexe, compte tenu d'un nombre important d'états à tester et ceci pour des temps de transition de l'ordre de quelques millisecondes.

Les dispositifs codeurs sont habituellement de deux types : soit "court-circuitants", c'est-à-dire qu'au passage d'une position à l'autre, deux positions à la fois sont momentanément indiquées, soit "non court-circuitants" auquel cas il existe une solution de continuité entre deux positions. Pour éviter cela, le document US-A-2,902,685 préconise l'utilisation d'afficheurs à tension d'amorçage plus élevée que leur tension de fonctionnement, en série avec une résistance commune à tous les afficheurs, de telle façon que l'allumage de l'un deux fait chuter la tension et empêche l'amorçage d'un deuxième, ce qui évite l'affichage de deux positions à la fois avec un codeur de type court-circuitant. Des résultats analogues pourraient être aisément obtenus avec des basculeurs semiconducteurs à seuil.

Le document DE-A- 22 47 777 décrit un dispositif qui peut procurer le même résultat lorsqu'on utilise des capteurs non court-circuitants : des bascules R/S enregistrent une position et la mémorisent pendant le temps de passage d'une position à l'autre.

Avec ces deux solutions, une tension sur une borne qui correspond à une position peut être appliquée à chaque instant sur une, et une seule desdites bornes. Par les mots "à chaque instant" on entend qu'à aucun moment la situation dans laquelle aucune tension ne serait appliquée à au moins une des bornes, ne peut se produire : ceci en négligeant, bien entendu les temps de transition intrinsèques des circuits électroniques utilisés.

L'invention se propose de fournir un dispositif, permettant la transmission d'une indication de position, qui soit peu volumineux, de faible consommation, très fiable et puisse fonctionner dans une large gamme de températures.

Tous ces buts sont atteints du fait que :

il comporte une série d'amplificateurs opérationnels à gain déterminé, munis chacun d'une entrée inverseuse et d'une entrée non inverseuse et travaillant dans une gamme de tension situées entre une tension limite plus positive et une tension limite plus négative par rapport à une tension intermédiaire,

la différence entre la susdite tension continue sur une borne de l'arrangement et la tension intermédiaire étant assez grande pour que l'application de cette différence entre les deux entrées d'un amplificateur amène pratiquement la sortie de ce dernier à une des tensions limites, chaque amplificateur a son entrée inverseuse reliée à une desdites bornes correspondant à une position, et son entrée non-inverseuse reliée à la borne correspondant à la position suivante,

chaque borne est munie de moyens pour que les bornes qui ne correspondent pas à la position momentanée de l'objet soient portées à la tension intermédiaire,

les sorties des amplificateurs sont reliées à un circuit de détection pour détecter sur l'une d'elles toute transition dont l'amplitude dépasse un seuil déterminé et délivrer alors un signal indiquant le sens de la transition, et ce signal sert à commander un dispositif compteur-décompteur dont la valeur de sortie est incrémentée ou décrémentée à chaque signal selon le sens de la transition, cette valeur de sortie constituant une indication de la position de l'objet.

Dans le cas fréquent où les positions de l'objet forment une boucle fermée, c'est-à-dire que la première position fait suite à la dernière et il en est de même pour les bornes, le dispositif comporte avantageusement un amplificateur dont l'entrée inverseuse est réunie à la dernière borne et l'entrée non-inverseuse est réunie à la première borne. Ainsi la série d'amplificateurs forme, elle aussi, une boucle fermée. Dans un tel cas, l'invention fournit l'avantage que la valeur fournie par le dispositif peut être plus grande que le nombre de positions de l'objet, et n'est limitée que par la capacité du dispositif compteur-décompteur.

L'organe à commander peut être, par exemple, l'émetteur-récepteur radio d'un avion. Il est utile que le pilote puisse sélectionner un canal préréglé (0 à 99, par exemple) sans avoir à regarder le bouton de commande. Il est donc particulièrement avantageux de pouvoir sélectionner rapidement l'un de ces canaux en effectuant plusieurs rotations d'un sélecteur à plots (à 12 ou 16 positions, par exemple, qui correspondent à ce qu'on a appelé plus haut "position de l'objet") et de lire le numéro de canal sur un répétiteur situé sur la planche de bord. Un bouton poussoir (axial au sélecteur) peut permettre, en outre, un retour rapide à la position 0 (RAZ).

Dans ces conditions, les informations de positionnement élaborées par le détecteur de positionnement sont envoyées, en codage numérique :
– d'une part à l'émetteur-récepteur pour aiguiller les fréquences préréglées correspondantes,
– d'autre part au dispositif de visualisation pour afficher le numéro de canal choisi.

Dans le cas où les positions de l'objet sont en nombre n multiple d'un nombre j, et peuvent donc être groupées en j groupes de i positions successives, avec $i \times j = n$, il est alors avantageux que l'arrangement comporte seulement i bornes, chacune d'elles correspondant à une même position dans chacun des j groupes, l'application de ladite tension sur une des i bornes indiquant la présence de l'objet à la position correspondante de l'un quelconque des j groupes. Ainsi on réalise une économie importante sur le nombre des amplificateurs.

Dans une forme avantageuse de réalisation de l'arrangement muni des bornes, il comporte un sélecteur rotatif non court-circuitant, suivi de bascules à verrouillage ("latches"), dont la sortie est reliée chaque fois à une desdites bornes. En outre, si le nombre des positions n'est pas premier, le nombre des bornes peut avantageusement être un diviseur du nombre des positions.

Du fait que la connexion de chaque borne à la sortie d'une bascule peut avoir pour résultat que les bornes correspondant aux positions autres que celle de l'objet sont portées à une tension non désirée, les bornes qui ne correspondent pas à la position de l'objet sont portées à la tension intermédiaire au moyen de résistances connectées entre chacune des bornes et la source de tension intermédiaire, associées à des diodes connectées entre chaque sortie de bascule à verrouillage et la borne correspondante.

Dans une forme de réalisation avantageuse, le circuit de détection pour détecter les transitions possédant autant d'entrées qu'il y a de bornes, chaque entrée est reliée via un condensateur, d'une part à une extrémité d'une résistance dont l'autre extrémité est connectée à un point de potentiel de référence, d'autre part à la cathode d'une première diode zener et à l'anode d'une seconde diode zener, toutes les premières diodes ont leurs anodes reliées ensemble, leur point commun étant relié à la masse par une résistance, et toutes les secondes diodes ont leurs cathodes reliées ensemble, leur point commun étant relié à la masse par une résistance.

Cette forme de réalisation permet d'obtenir un fonctionnement satisfaisant même si les temps de réponse des amplificateurs sont différents entre eux.

Dans un mode de réalisation du circuit de commande du dispositif compteur-décompteur, l'un desdits points commun est relié via un condensateur à l'entrée inverseuse d'un premier comparateur, et l'autre de la même façon à l'entrée non inverseuse d'un deuxième comparateur, ces comparateurs étant polarisés de façon telle que leurs sorties soient au repos dans le même état, ces sorties étant reliées chacune à une entrée d'une bascule R/S qui mémorise le sens de la transition et dont la sortie est appliquée à l'entrée de commande de sens de comptage du dispositif compteur-décompteur, et le circuit de commande comporte un ensemble comparateur qui délivre une impulsion lorsque l'un ou l'autre des points communs délivre un signal, l'impulsion étant identique dans les deux cas et appliquée à l'entrée d'horloge du dispositif compteur-décompteur.

La description qui va suivre, en regard des dessins annexés décrivant des exemples non limitatifs fera bien comprendre comment l'invention peut être réalisée .

La figure 1 est un schéma d'ensemble d'un dispositif selon l'invention.

La figure 2 représente schématiquement une partie d'un dispositif, pour illustrer le principe de base de l'invention.

La figure 3 représente une variante de la même partie d'un dispositif.

La figure 4 en représente une variante améliorée.

La figure 5 est un schéma détaillé d'un exemple de réalisation de l'invention, qui correspond au schéma de la figure 4.

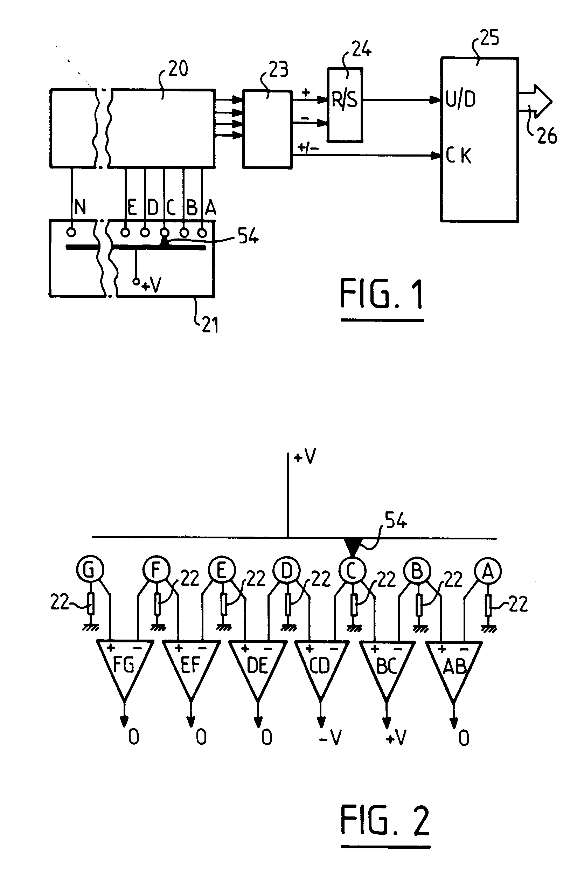

Sur le schéma-bloc de la figure 1, le rectangle 21 représente un arrangement avec plusieurs bornes A, B, C,...N dont chacune correspond à une des positions consécutives d'un objet. Il contient symboliquement un commutateur avec un élément de contact mobile 54, auquel est appliquée une tension continue +V, qui est amenée à une des bornes par l'élément de contact, la position de ce dernier correspondant à celle de l'objet. Cette tension est appliquée à chaque instant sur une et une seule des bornes : on entend par là que le curseur 54 est sensé passer instantanément d'une position à une autre. Bien entendu ceci est quasi-impossible à réaliser mécaniquement, mais peut néanmoins être obtenu par un circuit électronique disposé après un commutateur mécanique. Un exemple d'un tel circuit sera décrit plus loin, à propos d'un exemple détaillé de réalisation de l'invention.

Les bornes sont reliées à un élément 20 qui symbolise un circuit pour détecter un passage de la tension +V d'une borne à une autre. Cet élément contient une série d'amplificateurs dont le branchement sera expliqué plus en détail ci-après et dont les sorties sont amenées à un circuit de détection 23 qui détecte toute transition dont l'amplitude dépasse un seuil déterminé. Lors d'une telle transition, ce circuit délivre un bref signal, soit sur une sortie "+", soit sur une sortie "-", pour indiquer le sens de la transition. Il délivre en outre un bref signal "+/-" indépendant du sens de la transition. Les connexions portant les brefs signaux "+" ou "-" sont amenées à une bascule R/S 24 pour mémoriser le sens de la transition. Enfin la sortie de cette bascule 24 est appliquée à l'entrée de commande de sens de comptage d'un dispositif compteur-décompteur 25, et le signal "+/-" est amenée à son entrée d'horloge. La valeur de comptage de ce dispositif est donc incrémentée ou décrémentée à chaque transition selon le sens de la transition. Cette valeur de comptage est fournie numériquement sur un conducteur multifils 26. Elle représente une position de l'objet.

Le branchement de la série d'amplificateurs est montré à la figure 2. Chacun d'eux est un amplificateur opérationnel : on entend par là qu'il est muni de deux entrées, l'une inverseuse, l'autre non inverseuse, et qu'une même variation de tension appliquée à la fois aux deux entrées ne provoque pratiquement pas d'effet sur la tension de sortie. En outre ces amplificateurs ont un gain déterminé : on entend par là que si par exemple ils sont réalisés au moyen d'amplificateurs opérationnels en circuit intégré, ces derniers sont munis d'une boucle de contre-réaction pour en limiter le gain. Ces amplificateurs sont alimentés par une source de tension qui permet à leur sortie d'évoluer entre une tension limite plus positive et une tension limite plus négative par rapport à une tension intermédiaire. Ces tensions limites peuvent être respectivement une tension positive +V et une tension négative -V par rapport à la masse, ou bien l'une des tensions limites peut être celle de la masse et la tension intermédiaire égale à peu près à la moitié de l'autre tension limite.

Sur l'exemple de la figure 2, qui correspond au premier des deux cas ci-dessus, chaque borne A, B,...G est reliée à la source de tension intermédiaire, c'est-à-dire la masse, par une résistance 22. Ainsi, les bornes qui ne correspondent pas à la position momentanée de l'objet sont portées à la tension intermédiaire.

Ladite tension continue appliquée à une borne est ici +V. Elle pourrait aussi bien être -V, l'essentiel étant que la différence entre cette tension et la tension intermédiaire soit assez grande pour que l'application de cette différence entre les deux entrées d'un amplificateur amène pratiquement la sortie de ce dernier à une des tensions limites.

L'amplificateur AB a son entrée inverseuse - reliée à la borne A et son entrée non-inverseuse + reliée à la borne B qui correspond à la position suivante de l'objet. La même description s'applique respectivement à tous les amplificateurs en changeant les lettres de référence.

L'élément de contact 54, ou en pratique son équivalent électronique qui sera décrit plus loin, est ici sur la borne C, ainsi portée à la tension +V. Les bornes B et D sont liées à la tension intermédiaire via les résistances 22. La sortie de l'amplificateur CD est donc à -V, et celle de BC est à +V. Les autres amplificateurs AB, DE, EF, FG ont tous leurs deux entrées portées ensemble à la tension intermédiaire. Comme les amplificateurs sont munis d'une boucle de contre-réaction pour limiter leur gain, une petite différence parasite entre les tensions des deux entrées ne peut avoir beaucoup d'effet sur la tension de sortie. Celle-ci est donc à peu près égale à la tension intermédiaire. les tensions de sortie sont alors respectivement, en allant de la droite vers la gauche : 0, +V, -V, 0, 0, 0. Supposons que le contact 54 passe maintenant de C en D. Alors les tensions de sortie deviennent respectivement, toujours de la droite vers la gauche : 0, 0, +V, -V, 0,0. Trois transitions ont eu lieu sur les sorties : celle de BC est passée de +V à 0, celle de CD est passée de -V à +V, et celle de DE est passée de 0 à -V.

On a donc une "grande" transition -V/+V et deux "petites" transitions 0/-V ou +V/0.

Si le contact 54 passe de C en B, les tensions de sorties deviennent respectivement +V, -V, 0, 0, 0, 0. Le passage de C en B entraîne donc une transition 0/+V pour AB, +V/-V pour BC, -V/0 pour CD.

Si on ne s'intéresse qu'à la "grande" transition, on constate qu'elle est positive pour le passage de C vers D, et négative pour le passage de C vers B. Son sens indique donc le sens du déplacement de l'objet et peu importe sur lequel des amplificateurs elle a été produite.

Cette remarque est à la base de l'invention. Pour détecter les "grandes" transitions et négliger les "petites", il suffit de détecter toute transition dont l'amplitude dépasse un seuil déterminé, seuil dont la valeur est ici comprise entre une et deux fois V.

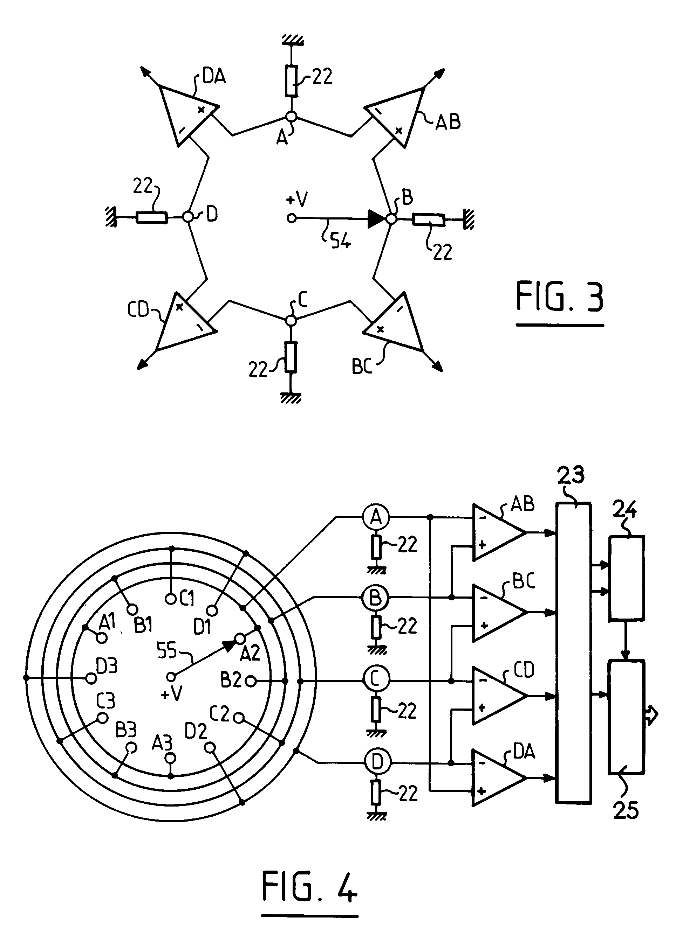

L'objet dont la position doit être indiquée par une valeur est la plupart du temps un organe de commande qui est actionné à la main et dont la position commande un organe situé à distance. Les bornes de la figure 2 correspondent par exemple à une manette de commande à curseur linéaire. Dans d'autres cas, la commande se fait par un bouton rotatif. C'est à ce cas que correspond le dispositif de la figure 3, qui comporte quatre bornes A, B, C, D, formant une boucle fermée, c'est-à-dire que la première position A fait suite à la dernière position D, et il en est bien entendu de même pour les positions de l'objet. Avec des bornes A, B, C, D en ligne comme sur la figure 2, le dispositif comprendrait les amplificateurs AB, BC, CD. Ici il comporte en plus l'amplificateur DA dont l'entrée inverseuse - est réunie à la dernière borne D, et l'entrée non-inverseuse + est réunie à la première borne A.

Il va de soi que toutes les entrées + et - pourraient être interverties sans rien changer au fonctionnement. Il suffirait alors d'énumérer les bornes en sens inverse pour se ramener à la même définition.

Avec le schéma de la figure 3, le fonctionnement présente une particularité intéressante : l'élément de contact 54 peut faire autant de tours que l'on désire. En supposant par exemple qu'il se déplace toujours dans le même sens, la série d'amplificateurs délivre une suite de transitions toutes identiques, tant que l'élément 54 continue à tourner, et le nombre des transitions peut être beaucoup plus grand que le nombre des bornes. Cette particularité est très avantageuse car il est possible avec un tel dispositif de fournir une valeur correspondant à un nombre de positions d'objet beaucoup plus grand que le nombre de positions du commutateur 54, cette valeur étant limitée seulement pour la capacité du compteur 25.

On peut, en outre, souhaiter utiliser un bouton rotatif qui comporte un plus grand nombre de positions que celui de la figure 3, par exemple pour permettre un emploi plus commode, l'angle de rotation nécessaire pour passer d'une position à une autre étant alors plus faible. Le schéma de la figure 4 est alors intéressant : il permet de réaliser le dispositif avec seulement quatre bornes et quatre amplificateurs, alors que le bouton rotatif 55 comporte ici douze positions correspondant à douze positions d'objet. La première position A1 est reliée à la cinquième position A2 et à la neuvième position A3, et de même les positions B1, B2, B3 sont réunies entre elles et les positions C1, C2, C3 aussi.

On pourrait prévoir d'une façon analogue un nombre n de positions du bouton qui soit un multiple j quelconque du nombre i de bornes. Alors, l'arrangement comporte seulement i bornes, chacune d'elles correspondant à une même position dans chacun des j groupes, l'application de ladite tension sur une des i bornes indiquant la présence de l'objet à la position correspondante de l'un quelconque des j groupes. Par exemple, une tension sur la borne A indique la présence du curseur 55 en A1, ou A2, ou A3. On peut lever le doute entre ces trois positions, si on a suivi pas à pas le déplacement du bouton à partir d'une position de départ connue.

S'il n'y a pas de butée pour le curseur, plusieurs tours de bouton sont permis, et il est alors nécessaire de prévoir un dispositif de remise à zéro du compteur 25, la position dite de départ étant celle où se trouve le bouton au moment de la remise à zéro.

Les dispositifs des figures 3 ou 4 pourraient aussi être imaginés avec trois bornes seulement. Néanmoins pour des raisons pratiques d'angle de positionnement (90°, 45°, 30°) des commutateurs rotatifs courants à 4, 8 ou 12 positions, le nombre de bornes préféré est de quatre. Le schéma électrique utilisé en pratique peut donc comporter un commutateur dont le nombre des positions est un multiple de quatre.

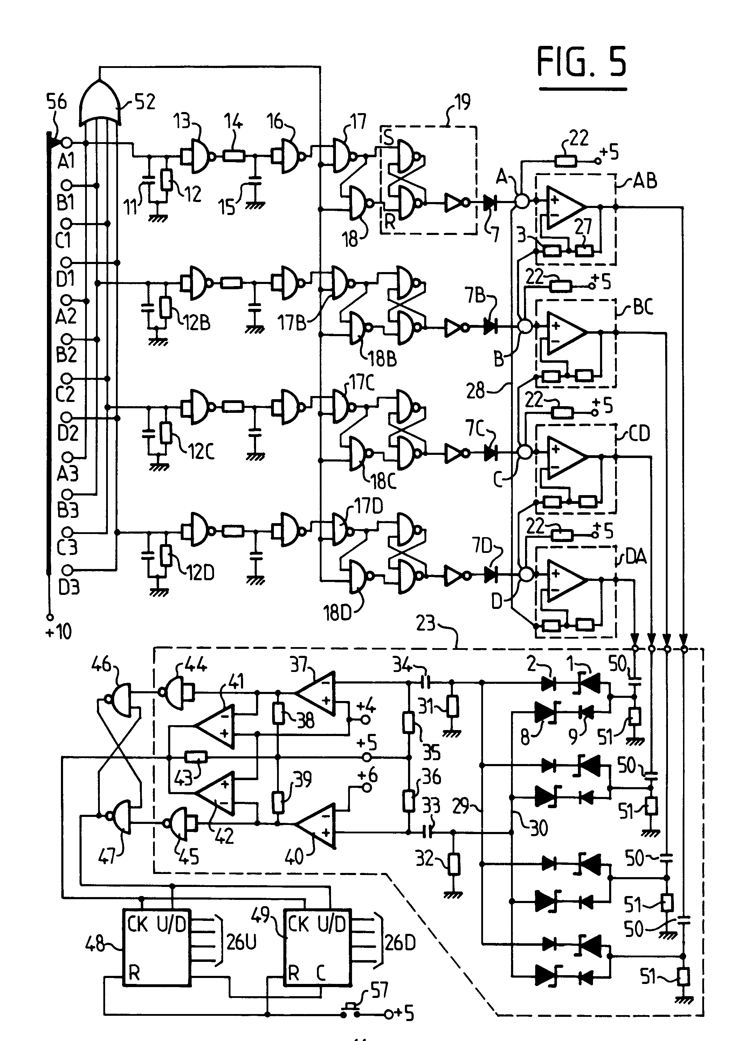

Sur la figure 5, les éléments correspondant à ceux des figures précédentes portent les mêmes références. Alors que le commutateur de la figure 4 est symbolique, celui de la figure 5 est un commutateur mécanique réel, correspondant par exemple à un bouton de commande des canaux d'un émetteur-récepteur de radio. Il est représenté avec 12 plots, mais peut en pratique en comporter un multiple de quatre plus élevé. Il s'agit d'un commutateur du type non court-circuitant. Il est représenté avec des plots en ligne pour gagner de la place sur la figure mais il s'agit en réalité d'un modèle rotatif dont le curseur 56 peut passer du plot D3 au plot A1.

Son curseur 55 est relié à une source de tension d'alimentation de 10 volts référencée +10. Ici les tensions limites sont zéro et +10, et la tension intermédiaire de cinq volts est référencée +5. Les plots du commutateur sont organisés en trois groupes de quatre plots : A1, B1, C1, D1 puis A2, B2, C2, D2, et enfin A3, B3, C3, D3. Les plots référencés par une même lettre sont chaque fois reliés ensemble et chaque ensemble est relié à une des quatre entrées d'une porte OU 52. Les plots A sont reliés à la masse par un condensateur 11 en parallèle avec une résistance 12, et il sont aussi reliés à l'entrée d'un inverseur 13 dont la sortie est reliée par une résistance 14 à l'entrée d'un deuxième inverseur 16, entrée qui est reliée à la masse par un condensateur 15. Ces deux inverseurs en cascade qui fournissent le même niveau logique qu'à l'entrée, ont seulement pour but d'éviter des anomalies de commutation (rebonds). La sortie de l'inverseur 16 est reliée à une première entrée d'une porte NON-ET 17 dont la sortie est reliée à une première entrée d'une porte NON-ET 18. Les deuxièmes entrées des deux portes 17 et 18 sont reliées à la sortie de la porte OU 52. Les sorties des portes 17 et 18 sont reliées reliées respectivement à l'entrée S et à l'entrée R d'une bascule R/S 19. Enfin la sortie de cette bascule 19 est reliée à l'anode d'une diode 7 dont la cathode est reliée à la borne A.

Chacun des trois autres ensembles de plots portant une même lettre est relié à l'entrée d'un groupe logique identique au groupe des éléments 11 à 19, groupe d'éléments dont la sortie est à chaque fois reliée de la même façon par une diode 7B, 7C, 7D à la borne référencée par la lettre correspondante. Les bornes A, B, C, D correspondent fonctionnellement à celles de la figure 4.

Le fonctionnement est le suivant : le curseur 56 applique la tension +10 au plot A1 relié à une entrée de la porte OU 52 dont la sortie reliée à une entrée de la porte 17 est donc à l'état haut. La sortie de l'inverseur 16 reliée à l'autre entrée de la porte 17 est aussi à l'état haut. La sortie de la porte 17 est donc à l'état bas, et en conséquence celle de la porte 18 est à l'état haut. La bascule R/S 19 délivre donc un état haut en sortie, appliqué à la borne A.

Tous les autres plots du commutateur étant "en l'air", les entrées des groupes logiques sont à l'état bas, du fait des résistances 12B, 12C, 12D. Les premières entrées des portes 17B, 17C, 17D sont donc à l'état bas, leurs sorties reliées respectivement aux premières entrées des portes 18A, 18B, 18C sont à l'état haut. Comme les deuxièmes entrées de ces portes 18 reliées à la sortie de la porte 52 sont aussi à l'état haut, leurs sorties sont à l'état bas, et il en est de même des sorties des bascules R/S qui suivent. Comme il y a une diode entre ces sorties et les bornes B, C, D, ces dernières ne sont pas abaissées au niveau bas, mais portées à la tension intermédiaire +5, grâce à des résistances 22, qui relient chaque borne à la source de tension +5.

Supposons maintenant que le curseur 56 quitte le plot A1. Pendant une période transitoire, tous les plots sont en l'air. Du fait des résistances 12, toutes les entrées de la porte 52 passent à l'état bas, et sa sortie aussi. Toutes les portes 17 et 18 passent à l'état haut en sortie, ce qui ne change rien à l'état des bascules R/S.

Lorsqu'un nouveau plot, B1 ou D3, est atteint par le curseur 56, la tension +10 est à nouveau appliquée à une entrée de la porte 52. On revient à l'état expliqué plus haut, en remplaçant "A" par "B" ou "D".

En conclusion : le passage à l'état haut d'une borne n'intervient qu'au moment où le curseur touche un plot, et entre temps l'état antérieur des bornes est maintenu. On a donc bien application à chaque instant d'une tension à une et une seule borne, les autres étant à la tension intermédiaire du fait des diodes 7 et des résistances 22. Une condition essentielle de bon fonctionnement du dispositif est qu'en aucun cas on ne puisse avoir deux bornes ensemble à l'état haut.

L'amplificateur opérationnel à gain déterminé AB est constitué ici d'un amplificateur à grand gain rebouclé sur son entrée inverseuse par un pont de résistances 27, 3, dont le rapport détermine le gain. C'est l'extrémité de la résistance 3 opposée au point commun du pont qui constitue l'entrée inverseuse de l'amplificateur AB, alors que l'entrée "+" de l'amplificateur à grand gain constitue directement l'entrée non-inverseuse. Les autres amplificateurs BC, CD, DA sont identiques. L'entrée non-inverseuse de AB est reliée à la borne A et son entrée inverseuse à la borne B, à laquelle est reliée à son tour l'entrée non inverseuse de BC, et ainsi de suite, l'entrée inverseuse de DA étant finalement reliée à la borne A par la connexion 28. Les sorties des quatre amplificateurs sont reliées chacune à une entrée du circuit 23 de détection de transitions. Chacune est reliée à un condensateur 50 en série avec une résistance 51 reliée à la masse. Du fait de l'action différenciatrice de ce circuit 50, 51 une impulsion brève apparaît à l'un des point commun de deux éléments 50, 51 à chaque changement brusque de tension en sortie d'un amplificateur. Chacun de ces points communs est connectée à l'anode d'une diode zener 1 et à la cathode d'une diode zener 8. Les diodes 2 et 9 ont pour rôle de bloquer le passage d'un courant dans le sens direct des diodes zener. les références 1, 2, 8, 9 ne sont indiquées qu'une fois pour ne pas alourdir la figure. La tension de seuil de chaque couple de diodes tel que 1, 2 ou 8, 9 est choisie entre 5 et 10 volts, de préférence plus proche de 5 volts.

Toutes les diodes zener dont l'anode est reliée par un condensateur à la sortie d'un amplificateur ont leurs cathodes reliées ensemble par une connexion 29 et toutes les autres ont leurs anodes reliées ensemble par une connexion 30. Chacune de ces deux connexions est reliée à la masse par une résistance, respectivement 31, 32 et via un condensateur respectivement 34, 33, à l'entrée d'un amplificateur opérationnel. L'entrée "-" de l'amplificateur 37 est reliée à la connexion 29, et l'entrée "+" de l'amplification 40 est reliée à la connexion 30. Chacune de ces deux entrées est par ailleurs reliée par une résistance, respectivement 35, 36, à la tension intermédiaire +5. L'entrée "+" de 37 est reliée à une tension de polarisation +4 volts, et l'entrée "-" de 40 est reliée à une tension de +6 volts. Les sorties de 37, 40 sont reliées chacune via un inverseur, respectivement 44, 45, à une entrée, respectivement R, S, d'une bascule R/S 46, 47 dont la sortie est reliée aux entrées U/D de commande de sens de comptage de deux compteurs-décompteurs 48, 49 (correspondant à 25 sur la figure 1). Les entrées "-" de deux autres amplificateurs 41, 42 sont reliées respectivement aux sorties des amplificateurs 37, 40, et leurs entrées "+" sont réunies à la tension +4 volts. Les sorties de ces deux autres amplificateurs sont reliées ensemble au +5 par une résistance 43 et à l'entrée d'horloge CK des compteurs-décompteurs. On a choisi ici des compteurs décimaux à sortie dite "BCD". La sortie de retenue du compteur 48 est reliée à l'entrée de retenue C du compteur 49. Les sorties 26U indiquent le chiffre des unités et les sorties 26D le chiffre des dizaines. La capacité de comptage du dispositif est donc de cent. Un interrupteur 57 relie le +5 aux entrées R de remise à zéro des compteurs 48 et 49, pour une remise à zéro définissant une position de départ de l'objet, c'est-à-dire du bouton de commande.

Lorsque la sortie d'un des amplificateurs AB, BC, CD, DA passe de zéro à 10 volts ou de 10 volts à zéro, il se produit au point commun de l'un des couples résistance-condensateur 50, 51, une impulsion d'environ dix volts. La tension de zener étant d'environ six volts, cette impulsion dépasse de quatre volts la tension de zener, et ces quatre volts se retrouvent sur une des connexions 29 ou 30 selon le sens de l'impulsion. Par contre, si la sortie d'un des amplificateurs AB, BC, CD, DA passe de zéro à 5 volts ou de 5 volts à zéro, l'impulsion est trop petite pour dépasser le seuil des diodes zener.

L'une ou l'autre des grandes impulsions sélectionnées par une des diodes zener est transmise par l'un des condensateurs 34 ou 33 vers une entrée d'un des amplificateurs 37 ou 40. Les résistances 35 et 36 reliées au +5 assurent la polarisation de repos : en l'absence d'impulsion les sorties des deux amplificateurs sont toutes deux dans le même état, près de la tension limite basse. Lorsqu'une impulsion négative arrive sur l'entrée inverseuse de l'amplificateur 37, sa sortie remonte près de 10 volts. De même, lorsqu'une impulsion positive arrive sur l'entrée non-inverseuse de l'amplificateur 40, sa sortie remonte près de 10 volts. Ces niveaux sont inversés par les inverseurs 44 ou 45.

Ce circuit 23 détecte donc les impulsions dont l'amplitude dépasse une certaine valeur, et fournit un signal sur l'une de ses deux sorties selon le sens de l'impulsion.

La bascule R/S 46, 47 (qui correspond à 24 sur la figure 1) reçoit donc au repos une valeur haute sur ses deux entrées, et est positionnée dans un de ses deux états par une impulsion négative sur l'une ou l'autre de ses entrées, ce qui permet d'indiquer au compteur 48, 49 son sens de comptage. Chaque impulsion positive en sortie des amplificateurs 37, 40 est appliquée aussi à l'entrée inverseuse de l'un ou l'autre des amplificateurs 41 ou 42, ce qui produit une impulsion positive en sortie, appliquée à l'entrée d'horloge CK du compteur : à chaque transition, quelle que soit son signe, un comptage d'une unité est déclenché, dans le sens indiqué par l'entrée U/D.

Bien entendu des variantes sont possibles sans sortir du cadre de l'invention : par exemple les impulsions pourraient être amenées aux entrées respectivement + et - des amplificateurs 37 et 40 en supprimant les inverseurs 44, 45, en adaptant les polarisations, et en intervertissant aussi les entrées des amplificateurs 41, 42. On pourrait aussi supprimer les diodes 7 et les résistances 22 en prenant le +5 volts comme tension d'alimentation inférieure des éléments logiques 13, 16, 17, 18, 19 ; mais les niveaux obtenus dépendraient des tolérances sur ces éléments, et seraient moins précis. On pourrait aussi utiliser une seule paire de diodes zeners tête-bêche, avec une seule résistance 51, reliée aux sorties des amplificateurs AB à DA par quatre condensateurs 50. On a constaté néanmoins que le fonctionnement est plus sûr avec quatre couples de diodes zeners , du fait des différences dans les temps de transition des amplificateurs. La connexion aux entrées des comparateurs 37, 40 pourrait aussi se faire sans les condensateurs 33, 34, si les comparateurs étaient branchés entre une tension positive et une tension négative, au lieu d'être branchés entre la masse et une tension...

Dans le mode de réalisation de l'invention qui vient d'être décrit, on a employé avec succès les éléments suivants :

portes et inverseurs 13, 16, 17, 44 à 47 : éléments d'un circuit intégré C-MOS. (par exemple HEF 4011 de marque Philips ou MC 14011 de marque Motorola).
Bascules R/S 19 : éléments d'un circuit HEF 4044 ou MC 14044.
Amplificateurs utilisés dans AB, BC, CD, DA : éléments d'un circuit LM 146.
Amplificateurs 37, 40, 41, 42 : éléments d'un circuit LM 139.
Compteurs-décompteurs 48, 49 : MC14510
Condensateurs 11,15    : 1nF

50                  : 0,1μF

33,34            : 10nF

Résistances 14 :       1 K.ohms

12, 22, 51, 31, 32, 38, 39, 43 = 10 K.ohms

3, 35, 36 : 100 K.ohms

27 : 1 Megohm.

Diodes Zener        1,8 : BZ X 55C 5V1

diodes 2, 7, 9 : 1N4148.

**Revendications**

1. Dispositif pour fournir une valeur indiquant la position d'un objet pouvant occuper au moins trois positions consécutives, comportant un arrangement avec plusieurs bornes (A, B,.....N) dont chacune correspond à une des positions, l'application d'une tension continue à chaque instant sur une et une seule desdites bornes indiquant la présence d'un objet dans la position correspondante, caractérisé en ce que :

il comporte une série d'amplificateurs opérationnels à gain déterminé (AB, BC, CD), munis chacun d'une entrée inverseuse (-) et d'une entrée non inverseuse (+) et travaillant dans une gamme de tensions situées entre une tension limite plus positive et une tension limite plus négative par rapport à une tension intermédiaire,

la différence entre la susdite tension continue sur une borne de l'arrangement et la tension intermédiaire étant assez grande pour que l'application de cette différence entre les deux entrées d'un amplificateur amène pratiquement la sortie de ce dernier à une des tensions limites, chaque amplificateur a son entrée inverseuse reliée à une desdites bornes correspondant à une position, et son entrée non-inverseuse reliée à la borne correspondant à la position suivante,

chaque borne est munie de moyens pour que les bornes qui ne correspondent pas à la position momentanée de l'objet soient portées à la tension intermédiaire,

les sorties des amplificateurs sont reliées à un circuit de détection (23,24) pour détecter sur l'une d'elles toute transition dont l'amplitude dépasse un seuil déterminé et délivrer alors un signal indiquant le sens de la transition, et ce signal sert à commander un dispositif compteur-décompteur (25) dont la valeur de sortie est incrémentée ou décrémentée à chaque signal selon le sens de la transition, cette valeur de sortie constituant une indication de la position de l'objet.

2. Dispositif selon la revendication 1, caractérisé en ce que les positions de l'objet forment une boucle fermée, c'est-à-dire que la première position fait suite à la dernière et il en est de même pour les bornes, et en ce que le dispositif comporte un amplificateur (DA) dont l'entrée inverseuse est réunie à la dernière borne et l'entrée non-inverseuse est réunie à la première borne.

3. Dispositif selon l'une des revendications 1 ou 2 caractérisé en ce que les positions de l'objet sont en nombre n multiple d'un nombre j, et peuvent donc être groupées en j groupes de i positions successives, avec i × j = n, et en ce que l'arrangement comporte seulement i bornes, chacune d'elles correspondant à une même position dans chacun des j groupes, l'application de ladite tension sur une des i bornes indiquant la présence de l'objet à la position correspondante de l'un quelconque des j groupes.

4. Dispositif selon la revendication 3, caractérisé en ce que i = 4.

5. Dispositif selon l'une quelconque des revendications 1 à 4, caractérisé en ce que l'arrangement comporte un sélecteur rotatif (55) non court-circuitant, suivi de bascules à verrouillage (19), dont la sortie est reliée chaque fois à une desdites bornes.

6. Dispositif selon la revendication 3, caractérisé en ce que l'arrangement comporte un sélecteur rotatif à n positions non court-circuitant, suivi de i bascules à verrouillage (19), dont la sortie est reliée chaque fois à une desdites bornes.

7. Dispositif selon l'une des revendication 5 ou 6, caractérisé en ce que les bornes qui ne correspondent pas à la position de l'objet sont portées à la tension intermédiaire au moyen de résistances (22) connectées entre chacune des bornes (A,B,C,D...) et la source de tension intermédiaire, associées à des diodes (7) connectées entre chaque sortie de bascule à verrouillage (19) et la borne correspondante.

8. Dispositif selon l'une quelconque des revendications 1 à 7, caractérisé en ce que, le circuit de détection (23,24) pour détecter les transitions possédant autant d'entrées qu'il y a de bornes, chaque entrée est reliée via un condensateur (50), d'une part à une extrémité d'une résistance (51) dont l'autre extrémité est connectée à un point de potentiel de référence, d'autre part à la cathode d'une première diode zener (1) et à l'anode d'une seconde diode zener (8), toutes les premières diodes ont leurs anodes reliées ensemble, leur point commun (29) étant relié à la masse par une résistance (31), et toutes les secondes diodes ont leurs cathodes reliées ensemble, leur point commun (30) étant relié à la masse par une résistance (32), le signal indiquant le sens d'une transition étant présent sous forme d'une impulsion sur l'un ou l'autre de ces points communs.

9. Dispositif selon la revendication 8, caractérisé en ce que l'un desdits points commun (29) est relié via un condensateur (34) à l'entrée inverseuse d'un premier comparateur (37), et l'autre (30 de la même façon à l'entrée non inverseuse d'un deuxième comparateur (40), ces comparateurs étant polarisés de façon telle que leurs sorties soient au repos dans le même état, ces sorties étant reliées chacune à une entrée d'une bascule R/S qui mémorise le sens de la transition et dont la sortie est appliquée à l'entrée de commande de sens de comptage du dispositif compteur-décompteur.

10. Dispositif selon la revendication 8, caractérisé en ce qu'il comporte en outre un ensemble comparateur qui délivre une impulsion lorsque l'un ou l'autre des points communs délivre un signal, l'impulsion étant identique dans les deux cas et appliquée à l'entrée d'horloge du dispositif compteur-décompteur (25).

## Claims

1. Device for providing a value indicating the position of an object which can occupy at least three consecutive positions, comprising an arrangement with several terminals (A, B, ..., N) each of which corresponding to one of the positions, the application of a DC voltage at each instant on one and only one of said terminals indicating the presence of an object in the corresponding position, characterized in that:

it comprises a series of operational amplifiers with specified gain (AB, BC, CD), each having an inverting input (-) and a non-inverting input (+) and working over a voltage range situated between a more positive limit voltage and a more negative limit voltage with respect to an intermediate voltage,

the difference between above-mentioned DC voltage on a terminal of the arrangement and the intermediate voltage being large enough for the application of this difference between the two inputs of an amplifier to practically take the output of the latter to one of the limit voltages, each amplifier has its inverting input connected to one of the terminals corresponding to one position, and its non-inverting input connected to the terminal corresponding to the next position,

each terminal is provided with means for taking terminals which do not correspond to the instantaneous position of the object, to the intermediate voltage,

the outputs of the amplifiers are connected to a detection circuit (23, 24) for detecting on one of them any transition whose amplitude exceeds a determined threshold and for then delivering a signal indicating the direction of the transition, and this signal is used to control an up/down counter means (25) whose output value is incremented or decremented with each signal depending on the direction of the transition, this output value constituting an indication of the position of the object.

2. Device as claimed in Claim 1, characterized in that the positions of the object form a closed loop, i.e. the first position follows the last position and the same applies to the terminals, and in that the device comprises an amplifier (DA) whose inverting input is connected to the last terminal and whose non-inverting input is connected to the first terminal.

3. Device as claimed in one of the Claims 1 or 2, characterized in that the number of positions of the object are a number n which is a multiple of a number j and can therefore be grouped into j sets of i successive positions, with i x j = n, and in that the arrangement comprises only i terminals, each of them corresponding to a same position in each of the j sets, while the application of said voltage on one of the i terminals indicates the presence of the object in the corresponding position of any one of the j sets.

4. Device as claimed in Claim 3, characterized in that i = 4.

5. Device as claimed in any of Claims 1 to 4, characterized in that the arrangement comprises a rotary non-short-circuiting selector (55), followed by latches (19), of which the output is connected each time to one of the terminals.

6. Device as claimed in Claim 3, characterized in that the arrangement comprises a non-short-circuiting rotary selector with n positions, followed by i latches, of which the output is connected each time to one of the terminals.

7. Device as claimed in one of Claims 5 or 6, characterized in that the terminals which do not correspond to the position of the object are carried to the intermediate voltage by means of resistors (22) connected between each of the terminals (A, B, C, D, ...) and the intermediate voltage source, associated with diodes (7) connected between each latch output (19) and the corresponding terminal.

8. Device as claimed in any of Claims 1 to 7, characterized in that the detection circuit (23, 24) for detecting the transitions has as many inputs as there are terminals, each input is connected across a capacitor (50), to one end of the resistor (51) whose other end is connected to a reference potential and also to the cathode of a first Zener diode (1) and to the anode of a second Zener diode (8), all the first diodes have their anodes connected together, their common point (29) being connected to ground through a resistor (31), and all the second diodes have their cathodes connected together, their common point (30) being connected to ground through a resistor (32), the signal indicating the direction of a transition being present in the form of a pulse on one or other of these common points.

9. Device as claimed in Claim 8, characterized in that one of the common points (29) is connected across a capacitor (34) to the inverting input of a first comparator (37), and the other one (30) is connected in the same way to the non-inverting input of a second comparator (40), these comparators being biased in such a way that their outputs have the same state when in the rest state, these outputs each being connected to one input

9

of an R/S flip-flop which stores the direction of the transition and whose output is applied to the input that controls the direction of counting of the up/down counter means.

10. Device as claimed in Claim 8, characterized in that it also comprises a comparator assembly which delivers a pulse when either one of the common points delivers a signal, the pulse being identical in both cases and applied to the clock input of the up/down counter means (25).

**Patentansprüche**

1. Einrichtung zum Liefern eines Wertes, der die Position eines Objektes, das mindestens drei aufeinanderfolgende Positionen einnehmen kann, anzeigt, mit einer Anordnung mit mehreren Anschlüssen (A,B,...,N), die jeweils einer der Positionen entsprechen, wobei das Zuführen einer Gleichspannung an einen und nur einen der Anschlüsse zu jedem Zeitpunkt das Vorhandensein eines Objektes in der entsprechenden Position anzeigt, dadurch gekennzeichnet, daß

die Einrichtung eine Reihe von Operationsverstärkern mit fester Verstärkung (AB,BC,CD) enthält, die jeweils mit einem invertierenden (-) und einem nicht-invertierenden (+) Eingang versehen sind und in einem Bereich von Spannungen arbeiten, die zwischen einer bezüglich einer Zwischenspannung positiveren Grenzspannung und einer negativeren Grenzspannung liegen,

wobei die Differenz zwischen der Gleichspannung an einem Anschluß der Anordnung und der Zwischenspannung groß genug ist, so daß die Zuführung dieser Differenz an die beiden Eingänge eines Verstärkers den Ausgang des Verstärkers praktisch auf eine der Grenzspannungen einstellt, wobei der invertierende Eingang jedes Verstärkers mit einem der Anschlüsse verbunden ist, der einer Position entspricht, und der nicht-invertierende Eingang mit dem Anschluß, der der folgenden Position entspricht,

jeder Anschluß mit Mitteln versehen ist, die dafür sorgen, daß die Anschlüsse, die nicht der momenten Position des Objektes entsprechen, auf der Zwischenspannung gehalten werden,

die Ausgänge der Verstärker mit einer Detektionsschaltung (23, 24) verbunden sind, um an einem der Ausgänge jeden Übergang zu detektieren, dessen Amplitude eine festgelegte Schwelle überschreitet und so ein Signal zu liefern, das die Richtung des Übergangs anzeigt, und dieses Signal dazu dient, eine Addierer-Subtrahierer-Anordnung (25) zu steuern, deren Ausgangswert bei jedem Signal je nach Richtung des Übergangs erhöht oder erniedrigt wird, wobei dieser Ausgangswert eine Anzeige der Position des Objektes bildet.

2. Einrichtung nach Anspruch 1, dadurch gekennzeichnet, daß die Positionen des Objektes eine geschlossene Schleife bilden, d. h. daß die erste Position an die letzte anschließt und dasselbe für die Anschlüsse gilt, und daß die Einrichtung einen Verstärker (DA) enthält, dessen invertierender Eingang mit dem letzten Anschluß verbunden ist, und dessen nicht-invertierender Eingang mit dem ersten Anschluß verbunden ist.

3. Einrichtung nach Anspruch 1 oder 2, dadurch gekennzeichnet, daß die Anzahl n der Positionen des Objektes ein Vielfaches einer Zahl j ist und die Positionen daher in j Gruppen von i aufeinanderfolgenden Positionen gruppiert werden können, mit i x j = n, und daß die Anordnung nur i Anschlüsse enthält, von denen jeder einer gleichen Position in jeder der j Gruppen entspricht, wobei das Zuführen der genannten Spannung an einen der i Anschlüsse das Vorhandensein des Objektes in der einer beliebigen der j Gruppen entsprechenden Position anzeigt.

4. Einrichnng nach Anspruch 3, dadurch gekennzeichnet, daß i = 4 ist.

5. Einrichtung nach einem der Ansprüche 1 bis 4, dadurch gekennzeichnet, daß die Anordnung einen nicht kurzschließenden Drehwähler (55), gefolgt von Speicher-Flip-Flops, enthält, dessen Ausgang jeweils mit einem der Anschlüsse verbunden wird.

6. Einrichtung nach Anspruch 3, dadurch gekennzeichnet, daß die Anordnung einen nicht kurzschließenden Drehwähler mit n Positionen, gefolgt von i Speicher-Flip-Flops enthält, dessen Ausgang jeweils mit einem der Anschüsse verbunden wird.

7. Einrichtung nach einem der Ansprüche 5 oder 6, dadurch gekennzeichnet, daß die der Position des Objektes nicht entsprechenden Anschlüsse mit Hilfe von Widerständen (22), die zwischen jeden der Anschlüsse (A,B,C,D...) und die Zwischenspannungsquelle geschaltet sind, zusammen mit Dioden (7), die zwischen jeden Ausgang eines Speicher-Flip-Flops (19) und den zugehörigen Anschluß geschaltet sind, auf der Zwischenspannung gehalten werden.

8. Einrichtung nach einem der Ansprüche 1 bis 7, dadurch gekennzeichnet, daß, während die Detektionsschaltung (23, 24) zur Detektion der Übergänge ebensoviele Eingänge hat, wie es Anschlüsse gibt, jeder Eingang über einen Kondensator (50) einerseits mit einem Ende eines Widerstands (51), dessen anderes Ende mit einem Bezugspotentialpunkt verbunden ist und andererseits mit der Kathode einer ersten Zenerdiode (1) und der Anode einer zweiten Zenerdiode (8) verbunden ist, alle ersten Dioden gemeinsam verbundene Anoden haben, wobei ihr gemeinsamer Punkt (29) über einen Widerstand (31) mit Masse verbunden ist, und alle zweiten Dioden gemeinsam verbundene Kathoden haben, wobei ihr gemeinsamer Punkt (30) über einen Widerstand (32) mit Masse verbunden ist, wobei das Signal die Richtung eines in Impulsform an dem einen oder anderen dieser gemeinsamen Punkte vorhandenen Übergangs anzeigt.

9. Einrichtung nach Anspruch 8, <u>dadurch gekennzeichnet</u>, daß einer der gemeinsamen Punkte (29) über einen Kondensator (34) mit dem invertierenden Eingang eines ersten Komparators (37) und der andere in gleicher Weise mit dem nichtinvertierenden Eingang eines zweiten Komparators (40) verbunden ist, wobei diese Komparatoren so vorgespannt sind, daß ihre Ausgänge in Ruhe im gleichen Zustand sind, und wobei diese Ausgänge jeweils mit einem Eingang eines R/S-Kippgliedes verbunden sind, das die Richtung des Übergangs speichert, und dessen Ausgang dem Steuereingang für die Zählrichtung der Addierer-Subtrahierer-Anordnung zugeführt wird

10. Einrichtung nach Anspruch 8, <u>dadurch gekennzeichnet</u>, daß sie auch ein Komparatorgebilde hat, das einen Impuls liefert, wenn einer der gemeinsamen Punkte ein Signal liefert, wobei der Impuls in den beiden Fällen identisch ist und dem Takteingang der Addierer-Subtrahierer-Anordnung (25) zugeführt wird.

FIG. 1

FIG. 2

FIG. 3

FIG. 4

FIG. 5